(19) Europäisches Patentamt
European Patent Office
Office européen des brevets

(11) EP 2 339 758 A1

(12) **DEMANDE DE BREVET EUROPEEN**

(43) Date de publication:
**29.06.2011 Bulletin 2011/26**

(51) Int Cl.:
*H04B 1/69* (2011.01)       *H03K 5/08* (2006.01)
*H03K 19/094* (2006.01)

(21) Numéro de dépôt: **09179459.4**

(22) Date de dépôt: **16.12.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA RS**

(71) Demandeur: **The Swatch Group Research and Development Ltd.**
**2074 Marin (CH)**

(72) Inventeur: **De Rosa, Luca**
**2072 St-Blaise (CH)**

(74) Mandataire: **Ravenel, Thierry Gérard Louis et al**
**ICB**
**Ingénieurs Conseils en Brevets SA**
**Faubourg de l'Hôpital 3**
**2001 Neuchâtel (CH)**

(54) **Circuit générateur d'impulsions dans un dispositif de transmission de signaux UWB**

(57) Le circuit générateur d'impulsions est prévu pour équiper un dispositif de transmission de signaux UWB. Le circuit comprend une paire différentielle de transistors (M0, M1), dont une première borne de courant de chaque transistor est reliée à une source de courant (Is), une seconde borne de courant du premier transistor (M0) étant reliée à une première résistance (R0) et une seconde borne de courant du second transistor (M1) étant reliée à une seconde résistance (R1). Une troisième résistance ajustable (Rcm) est reliée en série avec les résistances (R0, R1), les transistors et la source de courant entre deux bornes d'une source de tension d'alimentation (VDD). Le circuit comprend encore un premier conden- sateur (C0) relié au noeud de connexion du premier transistor (M0) et de la première résistance (R0) pour fournir un premier signal de sortie (out0), et un second condensateur (C1) relié au noeud de connexion du second transistor (M1) et de la seconde résistance (R1) pour fournir un second signal de sortie (out1). Chaque borne de com- mande des transistors (M0, M1) reçoit un signal binaire de données respectif (bit0, bit1) pour que le circuit fournisse le premier signal de sortie à impulsions (out0) et le second signal de sortie à impulsions (out1) inversées par rapport aux impulsions du premier signal de sortie, la forme de chaque impulsion dépendant de la charge et de la décharge de chaque condensateur (C0, C1).

Fig. 6

**Description**

L'invention concerne un circuit générateur d'impulsions en particulier dans un dispositif de transmission de signaux à ultra large bande (UWB).

Dans un système utilisant la technologie à ultra large bande (UWB), la transmission des données est effectuée par l'intermédiaire de signaux de données UWB, qui comprennent une succession d'impulsions très courtes avec ou sans l'utilisation d'une fréquence porteuse. Comme les impulsions sont très courtes par exemple de durée chacune inférieure ou égale à 2 ns, cela conduit à l'obtention d'un spectre à ultra large bande dans le domaine fréquentiel. Pour cette technologie UWB, le spectre défini de fréquences des signaux UWB doit se situer entre 3.1 et 10.6 GHz. Il peut aussi être prévu de diviser le spectre en plusieurs bandes de fréquence pour définir différents canaux de transmission parmi lesquelles 12 bandes de fréquence de l'ordre de 499.2 MHz.

Pour la reconnaissance du dispositif émetteur UWB par un dispositif récepteur UWB voisin, le codage des séquences d'impulsions des signaux de données transmises est en principe personnalisé au dispositif émetteur. Pour la transmission de données dans les signaux UWB, il peut être utilisé différents types de codage. Il peut être utilisé une modulation de position d'impulsions (PPM), une modulation d'amplitude des impulsions (PAM), une modulation de phase ou à décalage de phase (BPSK) des impulsions, une combinaison de modulation de position et de phase des impulsions, un codage binaire du type On-Off-Keying (OOK) en terminologie anglaise ou un autre type de modulation. La transmission de données par la technologie à ultra-large bande se fait normalement à courte distance avec une faible puissance des impulsions transmises.

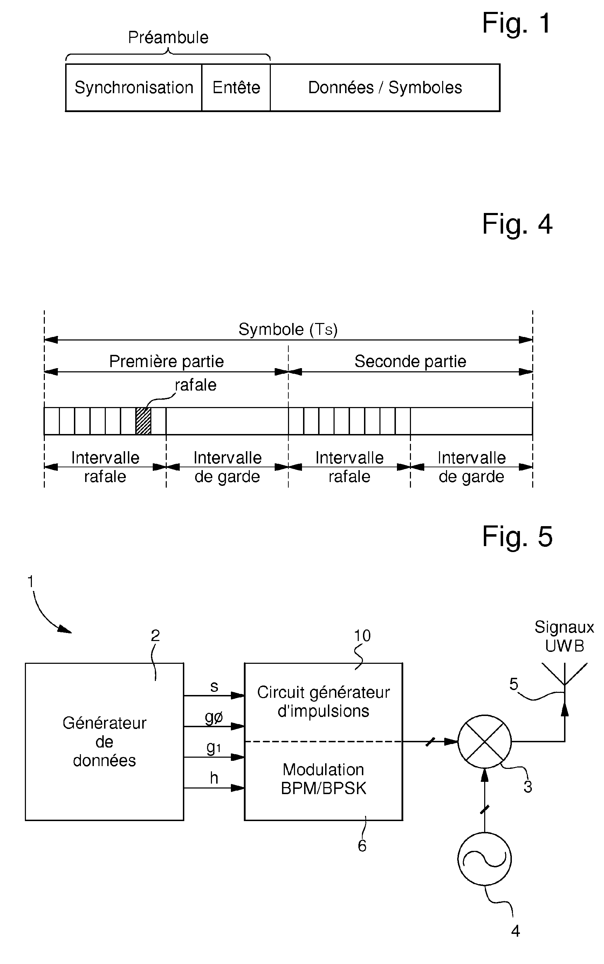

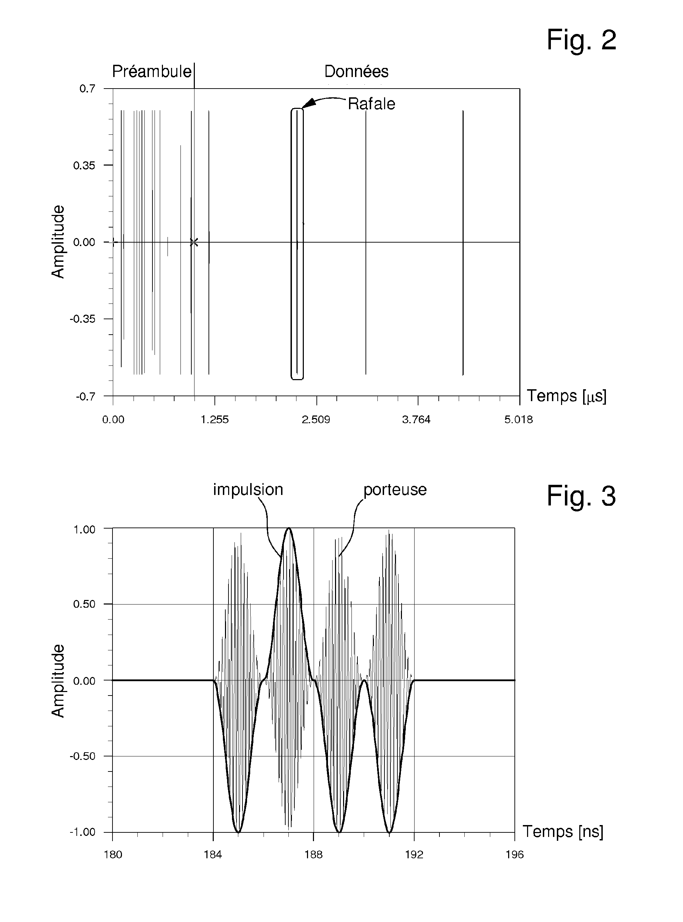

Il faut généralement comprendre par "données", une information textuelle comprenant un ou plusieurs symboles successifs, une information de synchronisation ou d'autres informations. Comme on peut le voir schématiquement à la figure 1 et de manière simplifiée dans le temps à la figure 2, les signaux UWB comprennent tout d'abord un préambule, qui est suivi des données de la succession de symboles à transmettre. Pour la présente invention, ces signaux UWB peuvent être définis selon un standard IEEE 802.15.4a (du 31 août 2007), qui est un amendement du précédent standard IEEE 802.15.4, et intitulé "Wireless Medium Access Control (MAC) and Physical Layer (PHY) Specifications for Low-Rate Wireless Personal Area Networks (LRW-PANs) de septembre 2006.

Le préambule des signaux UWB débute notamment par une partie de synchronisation, qui permet également de fournir une estimation de canal et une mesure de distance entre le dispositif émetteur et le dispositif récepteur. Cette partie de synchronisation comprend plusieurs impulsions suffisamment espacées les unes des autres et définissant un code ternaire. Elle peut comprendre par exemple entre 16 et 4096 symboles, où chaque symbole est codé par un unique code ternaire de longueur 31 ou 127. Le préambule comprend encore à la suite de la partie de synchronisation, une partie d'entête, qui a pour rôle de transmettre des informations nécessaires pour bien décoder des bits de la succession des impulsions ou rafales d'impulsions. Cette partie d'entête est modulée selon le principe de la modulation de position des rafales d'impulsions (BPM) et de la modulation de phase à deux états (BPSK) expliqués ci-après en référence à la figure 4. Cette partie d'entête peut comprendre jusqu'à 19 symboles. Les données composées de plusieurs symboles successifs sont transmises directement à la suite de la partie d'entête.

Comme montré à la figure 3, le codage des symboles de la partie d'entête, et principalement de la partie des données proprement dite, comprend une succession d'impulsions définissant une rafale ou "burst" en terminologie anglaise. Chaque rafale d'impulsions d'un symbole est suffisamment espacée d'une autre rafale d'impulsions d'un symbole successif. Les impulsions négatives définissent un état "-1", alors que les impulsions positives définissent un état "+1", alors qu'aucune impulsion définit un état "0". Comme les signaux UWB comprennent une fréquence porteuse située entre 3.1 et 10.6 GHz, par exemple à 6 ou 8 GHz sur laquelle sont modulées lesdites impulsions, chaque impulsion constitue l'enveloppe positive ou négative du signal sinusoïdal à fréquence porteuse comme montré à la figure 3. L'état "-1" et "+1" de chaque impulsion est fonction d'un déphasage de 180° de la porteuse.

Chaque symbole modulé en position (BPM) et en phase (BPSK) est représenté schématiquement à la figure 4. Chaque symbole est d'une durée Ts, qui peut valoir par exemple 1024 ns. Pour la modulation de position, il est prévu une première partie de durée Ts/2, et une seconde partie de durée Ts/2. Chaque partie comprend un intervalle pour la rafale d'impulsions, pour définir les positions possibles de la rafale d'impulsions, et un intervalle de garde pour bien séparer les deux états de la modulation, et limiter l'interférence entre chaque symbole. Chaque intervalle est de même durée Ts/4.

Comme représenté à la figure 4, il est prévu 8 positions pour la rafale d'impulsions (burst en terminologie anglaise), qui normalement correspond à 16 impulsions pour chaque rafale. Cependant il peut également être envisagé d'avoir 32 positions pour la rafale d'impulsions, qui comprend dans ce cas 4 impulsions. Bien entendu comme représenté à la figure 3, chaque rafale d'impulsions comprend une série d'impulsions positives et/ou négatives (BPSK) définissant un codage personnalisé au dispositif émetteur.

Habituellement les impulsions générées pour coder notamment sur deux bits chaque symbole, sont de forme gaussienne. De telles impulsions ne peuvent être générées qu'au moyen d'un circuit générateur relativement complexe, ce qui est un inconvénient. Ces impulsions de forme gaussienne peuvent également être transmises sans porteuse selon l'état de la technique dans les signaux UWB. Un tel circuit générateur d'impulsions complexe de l'état de la technique, comme montré dans la demande de brevet WO 2005/067160, doit être alimenté à une tension d'alimentation proche des 2 V, ce qui est un autre inconvénient, car cela ne permet pas de réduire la consommation d'un dispositif émetteur de signaux UWB, qui comprend un tel circuit générateur d'impulsions. De plus la gestion des paramètres, qui caractérisent les impulsions générées, comprend des variables, qui peuvent être modifiées sur la base de plusieurs composants du circuit générateur, ce qui est un autre inconvénient.

L'invention a donc pour but de pallier aux inconvénients cités ci-devant en fournissant un circuit générateur d'impulsions pour un dispositif de transmission de signaux UWB, qui soit de conception simple pour la génération d'impulsions respectant les contraintes notamment du standard IEEE 802.15.4a, et avec une gestion des paramètres avec un nombre de variables très limité.

A cet effet, l'invention concerne un circuit générateur d'impulsions du type UWB cité ci-devant, qui comprend les caractéristiques définies dans la revendication indépendante 1.

Des formes d'exécution particulières du circuit générateur d'impulsions sont définies dans les revendications dépendantes 2 à 9.

Un avantage du circuit générateur d'impulsions du type UWB réside dans le fait qu'il permet avec une structure simple sur la base de la charge et décharge de condensateurs de générer des impulsions pour respecter notamment le standard IEEE 802.15.4a. Comme le nombre de variables est avantageusement réduit à deux avec une résistance et un condensateur de chaque côté de la paire différentielle de transistors, il est facile de modifier la forme de chaque impulsion. Chaque impulsion notamment de forme exponentielle, peut être configurée sous forme triangulaire ou sous forme rectangulaire dans le masque spectral du standard IEEE 802.15.4a.

Avantageusement comme le circuit générateur d'impulsions comprend une structure en montage différentiel avec deux résistances et deux condensateurs, il peut fournir un code ternaire par des signaux binaires de données appliqués respectivement sur chaque grille des transistors MOS de la paire différentielle.

A cet effet, l'invention concerne également un dispositif de transmission de signaux UWB muni du circuit générateur d'impulsions, qui comprend les caractéristiques définies dans la revendication 10.

Des formes d'exécution particulière du dispositif de transmission de signaux UWB sont définies dans les revendications dépendantes 11 à 13.

Les buts, avantages et caractéristiques du circuit générateur d'impulsions dans un dispositif de transmission de signaux UWB, apparaîtront mieux dans la description suivante sur la base d'au moins une forme d'exécution non limitative illustrée par les dessins sur lesquels :

la figure 1 déjà citée représente de manière simplifiée le format d'une trame d'information dans les signaux UWB transmis par le dispositif de transmission,

la figure 2 déjà citée représente des impulsions dans le temps de manière schématique d'une trame d'information dans les signaux UWB transmis par le dispositif de transmission,

la figure 3 déjà citée représente la forme d'une rafale d'impulsions d'un symbole des données à transmettre en sortie d'un dispositif de transmission de signaux UWB,

la figure 4 déjà citée représente la structure pour la modulation de chaque symbole des données à transmettre dans les signaux UWB,

la figure 5 représente de manière simplifiée un dispositif de transmission de signaux UWB, qui comprend un circuit générateur d'impulsions selon l'invention,

la figure 6 représente une forme d'exécution d'un circuit générateur d'impulsions selon l'invention pour un dispositif de transmission de signaux UWB,

la figure 7 représente un graphique d'une réponse transitoire d'un signal de sortie en fonction des signaux binaires appliqués sur les grilles des transistors MOS de la paire différentielle du circuit générateur d'impulsions selon l'invention, et

les figures 8a et 8b représentent d'une part une forme générée d'impulsion transmise par le dispositif de transmission de signaux UWB et d'autre part le spectre de cette impulsion générée avec la fréquence porteuse dans le masque, qui définit l'intersection des masques de limite d'émission dans le monde et du masque spectral du standard IEEE 802.15.4a.

Dans la description suivante, tous les éléments qui composent le dispositif de transmission de signaux UWB, qui sont bien connus de l'homme du métier dans ce domaine technique ne sont relatés que de manière simplifiée.

Le dispositif de transmission de signaux UWB 1, qui comprend le circuit générateur d'impulsions 10 selon l'invention, est représenté de manière simplifiée à la figure 5. Il est composé essentiellement d'un générateur de données 2, du circuit générateur d'impulsions 10, d'une unité de modulation BPM/BPSK 6 combinée au circuit générateur d'impulsions, d'un oscillateur local 4, d'un mélangeur 3 et d'une antenne 5 pour la transmission des signaux UWB. Les signaux UWB transmis par l'antenne sont avantageusement composés d'un préambule de synchronisation et d'une série de symboles de données à la suite du préambule comme représentée de manière simplifiée à la figure 1. Les signaux UWB comprennent pour chaque symbole transmis une impulsion ou une rafale d'impulsions modulées en position et en phase, ce qui définit deux bits, et converties en fréquence sur une fréquence porteuse située entre 3.1 GHz et 10.6 GHz. La fréquence porteuse des signaux UWB peut être déterminée pour la transmission des données par exemple dans une parmi les 12 bandes de fréquences de 499.2 MHz dans la largeur de bande de 3.1 GHz et 10.6 GHz du spectre UWB. Il peut être choisi par exemple la fréquence porteuse à 7.9872 GHz.

Dans une phase de transmission de signaux UWB, le générateur de données 2 fournit des signaux numériques de données s, g0, g1 et h à l'ensemble composé de l'unité 6 de modulation de position (BPM) et de phase (BPSK) et du circuit générateur d'impulsions 10 de la présente invention. Les signaux numériques de données ou vecteurs s, g0, g1 et h sont définis dans la formule suivante de l'expression temporelle d'un $k^{\text{ième}}$ symbole des données à transmettre :

$$x(t) = (1\text{-}2{\cdot}g_1){\cdot}\sum\nolimits_n(1\text{-}2{\cdot}s_k){\cdot}p(t\text{-}n{\cdot}T_c\text{-}g_0{\cdot}T_{BPM}\text{-}h{\cdot}T_r)$$

où il est effectué une somme pour n = 1 à $N_c$, qui représente le nombre de chips (impulsions) par rafale, $g_1$ définit le bit d'information de phase de la rafale d'impulsions, $S_k$ définit la séquence d'étalement durant le $k^{\text{ième}}$ symbole, p(t) définit l'allure temporelle de l'impulsion transmise, $T_c$ définit la durée d'un chip, $g_0$ définit le bit d'information de position de la rafale, $T_{BPM}$ définit la durée d'une première partie ou seconde partie du symbole, h définit la séquence de type TH (Time-Hopping en terminologie anglaise), et finalement $T_r$ définit la durée d'une rafale.

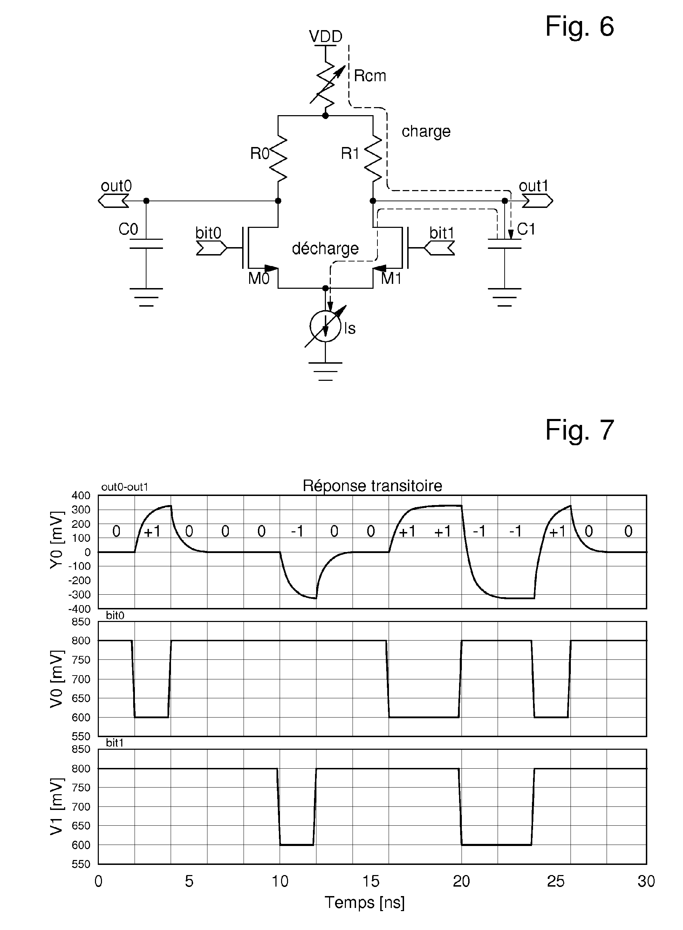

La modulation de position et de phase d'au moins une impulsion ou d'une rafale d'impulsions par symbole de données est défini selon l'agencement représenté à la figure 4. Cette modulation de position et de phase est gérée par l'unité 6 de modulation de position et de phase afin que des signaux binaires soient fournis au circuit générateur d'impulsions 10. Sur la base des signaux binaires reçus, le circuit générateur d'impulsions fournit deux signaux de sortie à impulsions comme expliqués plus en détail ci-après en référence à la figure 6. Au moins un des signaux de sortie à impulsions du circuit générateur d'impulsions est mélangé dans un simple mélangeur 3 à au moins un signal à fréquence porteuse fourni par l'oscillateur local 4. Ceci permet de convertir en fréquence le signal de sortie sur la fréquence porteuse. Le simple mélangeur 3 fournit des signaux UWB à impulsions de données directement à l'antenne de transmission 5 pour être transmis à au moins un dispositif récepteur voisin.

Il est à noter qu'il peut être utilisé de préférence un double mélangeur 3 dans lequel un premier signal de sortie du circuit générateur d'impulsions 10 est mélangé à un premier signal à fréquence porteuse de l'oscillateur local 4, et un second signal de sortie du circuit générateur d'impulsions, complémentaire au premier signal de sortie, est mélangé à un second signal à fréquence porteuse déphasé de 180 par rapport au premier signal à fréquence porteuse. De cette manière, cela renforce les signaux UWB à impulsions de données à transmettre par l'antenne 5.

Une forme d'exécution du circuit générateur d'impulsions de la présente invention est maintenant décrite de manière plus détaillée en référence à la figure 6. Le circuit générateur d'impulsions est destiné à faire partie du dispositif de transmission de signaux comme expliqué ci-dessus. Il est alimenté par une source de tension d'alimentation à faible tension, qui est de préférence inférieure à 1 V, ce qui réduit considérablement la consommation du circuit générateur d'impulsions par rapport à l'état de la technique. Un tel circuit générateur d'impulsions peut être réalisé sous forme intégrée par exemple dans une technologie CMOS à 0.18 $\mu$m.

Ce circuit générateur d'impulsions comprend une paire différentielle de transistors NMOS M0, M1, qui sont de même dimension et appariés. Une première borne de courant de chaque transistor, qui est une borne de source, est reliée à une source de courant Is ajustable, qui est reliée à une borne de potentiel bas, telle que la masse d'une source de tension d'alimentation non représentée. Une seconde borne de courant ou borne de drain du premier transistor NMOS M0 est reliée à une première résistance R0 et une seconde borne de courant ou borne de drain du second transistor NMOS M1 est reliée à une seconde résistance R1. Les résistances R0 et R1 ont de préférence une même valeur résistive fixe et sont donc appariées. Une troisième résistance ajustable Rcm est encore reliée d'une part à une borne de potentiel haut VDD de la source de tension d'alimentation et aux deux résistances R0, R1 d'un côté opposé à leur connexion aux transistors NMOS correspondants M0, M1. La troisième résistance Rcm, les deux résistances R0, R1, les deux transistors NMOS M0, M1 et la source de courant Is sont donc reliés en série entre les deux bornes de la source de tension d'alimentation.

Le circuit générateur d'impulsions comprend encore un premier condensateur C0, dont une borne est reliée au noeud de connexion du premier transistor M0 et de la première résistance R0, et l'autre borne est de préférence reliée à la borne de potentiel bas de la source de tension d'alimentation. Un premier signal de sortie à impulsions out0 est fourni au noeud de connexion entre le premier condensateur C0, la première résistance R0 et le premier transistor NMOS M0. Le circuit générateur d'impulsions comprend également un second condensateur C1 dont une borne est reliée au noeud de connexion du second transistor M1 et de la seconde résistance R1, et l'autre borne est de préférence reliée à la borne de potentiel bas de la source de tension d'alimentation. Un second signal de sortie à impulsions out1 est fourni au noeud de connexion entre le second condensateur C1, la seconde résistance R1 et le second transistor NMOS M1. Les condensateurs C0 et C1 ont de préférence une même valeur capacitive et sont appariés.

Chaque borne de commande ou borne de grille des deux transistors NMOS M0, M1 est destinée à recevoir un signal binaire de données respectif bit0, bit1 dans le dispositif de transmission de signaux UWB. Ces signaux binaires (deux bits) sont obtenus sur la base des signaux numériques fournis par le générateur de données du dispositif et de la modulation de position BPM et de phase BPSK des impulsions dans l'unité de modulation du dispositif comme expliqué ci-devant. Selon le niveau en tension de chaque signal binaire bit0, bit1, chaque transistor NMOS peut être rendu conducteur ou non conducteur ou moins conducteur que l'autre transistor NMOS de manière que chaque signal de sortie à impulsions définisse un code ternaire pour chaque symbole des données à transmettre. Les impulsions du premier signal de sortie out0 sont inversées par rapport aux impulsions du second signal de sortie out1.

Un état "0" du code ternaire dans le premier signal de sortie out0 ou dans le second signal de sortie out1 est obtenu quand les deux transistors NMOS M0, M1 sont rendus conducteurs. Un état "1" dans le premier signal de sortie out0 et inversement un état "-1" dans le second signal de sortie out1 sont obtenus quand le premier transistor NMOS M0 est non conducteur ou moins conducteur que le second transistor NMOS M1 en conduction. Un état "-1" dans le premier signal de sortie out0 et inversement un état "1" dans le second signal de sortie out1 sont obtenus quand le second transistor NMOS M1 est non conducteur ou moins conducteur que le premier transistor NMOS M0 en conduction.

Pour mieux représenter la forme des impulsions obtenues dans chaque signal de sortie en fonction de l'état de chaque signal binaire, on peut se reporter aux graphes de la réponse transitoire en sortie montrés à la figure 7. Les impulsions représentées sur cette figure 7 ne correspondent bien évidemment pas directement à l'agencement des impulsions requis de chaque symbole de données à transmettre pour tenir compte du masque spectral du standard IEEE 802.15.4a. Cependant il est représenté la forme des impulsions suite à la charge et à la décharge des condensateurs du circuit générateur d'impulsions, dont la durée de chaque impulsion est de l'ordre de 2 ns.

Sur cette figure 7, il est représenté la forme en tension dans le temps d'un signal différentiel de sortie Y0 (out0-out1) en fonction des signaux binaires V0 (bit0) et V1 (bit1) appliqués aux bornes de grille respectives des deux transistors NMOS. Comme décrit ci-devant, lorsque les deux transistors NMOS sont rendus conducteurs par une même tension de grille supérieure à la tension de seuil de chacun des transistors NMOS, le courant de la source de courant Is est réparti à parts égales dans les deux branches des deux transistors NMOS. La tension de grille peut être établie à 0.8 V par exemple. Chaque résistance R0 ou R1 reçoit la moitié du courant de ladite source de courant Is. Dans ces conditions, la valeur des résistances R0, R1, Rcm doit notamment être adaptée en fonction de la valeur de courant de la source de courant Is. Chaque signal de sortie représente ainsi un état "0" avec un niveau de tension situé à une tension intermédiaire VDD/2 par rapport à la tension VDD de la source de tension d'alimentation. Le signal de sortie Y0, qui est un signal différentiel, peut être référencé par rapport à une tension intermédiaire VDD/2. Par conséquent, ce signal différentiel est situé à une tension nulle.

Lorsque la tension de grille du premier transistor NMOS M0 est diminuée d'une certaine valeur par rapport à la tension de grille du second transistor NMOS M1, une impulsion positive définissant un état "1" dans le premier signal de sortie out0 est produite à la suite d'un état "0". La tension de grille du premier transistor NMOS M0 n'a pas besoin d'être abaissée jusqu'à 0 V, mais peut être abaissée jusqu'à 0.6 V pour que tout le courant de la source de courant Is traverse le second transistor NMOS M1. Dès l'instant du passage de l'état "0" à l'état "1" en abaissant la tension de grille du premier transistor NMOS M0 de 0.8 V à 0.6 V et en maintenant 0.8 V sur la borne de grille du second transistor NMOS M1, le premier condensateur C0 de la figure 6 est dans une phase de charge avec un courant traversant la première résistance R0 et la troisième résistance Rcm. Inversement une impulsion négative définissant un état "-1" dans le second signal de sortie out1, est produite par décharge du second condensateur C1 à travers le second transistor NMOS M1.

La valeur de courant Is est au départ de l'état "0" deux fois plus importante que celle du courant passant à travers la seconde résistance R1 et la première résistance R0, alors que la troisième résistance Rcm est traversée par le courant Is. Dans le cas où le signal bit1 passe de 0 à 1 et le signal bit0 passe de 1 à 0, il y a une opération de décharge du second condensateur C1, et inversement une opération de charge du premier condensateur C0. Le second transistor est mis en conduction, ce qui fait que le courant dans la branche, qui comprend le second transistor M1 et la seconde résistance R1 augmente. Par contre, le courant diminue de la même quantité dans la branche, qui comprend le premier transistor M0 non conducteur et la première résistance R0. Etant donné que les variations de courant/tension sont en valeurs absolues égales dans les deux branches, il en découle que les formes de charge/décharge de chaque condensateur sont similaires.

Lorsque la tension de grille du premier transistor NMOS M0 depuis un état "1" revient à un niveau équivalent de la tension de grille du second transistor NMOS M1, une décharge du premier condensateur C0 s'opère. Par contre, une charge du second condensateur C1 est réalisée comme le courant de la source de courant Is est réparti à parts égales dans chaque branche de la paire différentielle de transistors NMOS. Ainsi de multiples opérations de charge et décharge des deux condensateurs sont réalisées pour définir des signaux de sortie à impulsions définissant un code ternaire.

La forme des impulsions obtenues dans chaque signal de sortie par la charge et décharge des condensateurs peut être adaptée notamment par l'intermédiaire de la troisième résistance Rcm ou également en modifiant quelque peu la valeur de courant de la source de courant Is. Cependant la forme des impulsions obtenues peut aussi être modifiée en adaptant la valeur des condensateurs C0 et C1. Avec cela, il est facile de produire des signaux de sortie ayant des impulsions de forme triangulaire ou de forme rectangulaire en ne modifiant que peu de variables du circuit générateur d'impulsions selon la présente invention.

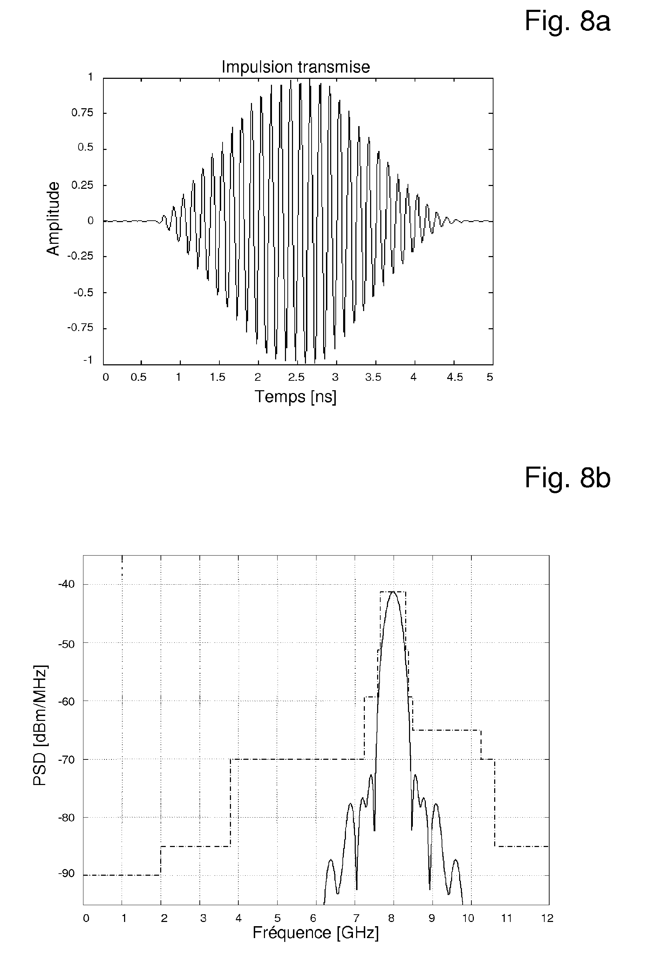

A titre d'exemple non limitatif, il peut être prévu que la valeur résistive des première et seconde résistances R0, R1 soit de l'ordre de 900 Ohms, alors que la valeur résistance de la troisième résistance Rcm est comprise entre 900 Ohms et 9 kOhms. Chaque condensateur C0 et C1 peut avoir une valeur capacitive de l'ordre de 300 fF. Dans le cas de modification de la valeur capacitive des condensateurs, cette modification peut être effectuée par pas de 50 fF. La valeur de courant de la source de courant peut varier entre 200 pA et 400 pA par exemple. En augmentant la valeur RC, la rampe de charge et de décharge devient plus lente, et inversement en diminuant cette valeur RC dans chaque branche. De ce fait, il est loisible de passer d'une forme d'impulsion triangulaire à une forme d'impulsion rectangulaire. Entre ces deux limites, le circuit générateur peut produire des impulsions de forme exponentielle en variant la vitesse de charge et de décharge des condensateurs. Toutefois, les impulsions obtenues par l'intermédiaire du circuit générateur d'impulsions doivent respecter de préférence le standard IEEE 802.15.4a, comme montré aux figures 8a et 8b. L'impulsion générée avec la fréquence porteuse doit se trouver à l'intérieur du masque spectral montré en traits interrompus sur la figure 8b selon ce standard de l'IEEE.

A partir de la description qui vient d'être faite, plusieurs variantes du circuit générateur d'impulsions dans un dispositif de transmission de signaux UWB peuvent être conçues par l'homme du métier sans sortir du cadre de l'invention définie par les revendications. La paire différentielle de transistors peut être composée de transistors du type PMOS avec un agencement inversé de la source de courant, des résistances et des condensateurs entre les bornes de la source de tension d'alimentation. Il peut être envisagé d'utiliser des transistors bipolaires du type NPN pour remplacer les transistors NMOS ou du type PNP pour remplacer les transistors PMOS. Il peut être prévu d'ajuster la valeur résistive de la troisième résistance avec la valeur de courant de la source de courant de manière à garantir des formes d'impulsion différentes, mais également pour avoir un état "0" situé à une tension intermédiaire par rapport à la tension de la source de tension d'alimentation.

**Revendications**

1. Circuit générateur d'impulsions (10) pour un dispositif de transmission de signaux UWB (1), **caractérisé en ce qu'**il comprend :

   - une paire différentielle de transistors (M0, M1), dont une première borne de courant de chaque transistor est reliée à une source de courant (Is), une seconde borne de courant du premier transistor (M0) étant reliée à une première résistance (R0) et une seconde borne de courant du second transistor (M1) étant reliée à une seconde résistance (R1), les résistances, les transistors et la source de courant étant reliés en série entre deux bornes d'une source de tension d'alimentation (VDD),
   - un premier condensateur (C0) relié au noeud de connexion du premier transistor (M0) et de la première résistance (R0) pour fournir un premier signal de sortie (out0), et un second condensateur (C1) relié au noeud de connexion du second transistor (M1) et de la seconde résistance (R1) pour fournir un second signal de sortie (out1), et

   **en ce que** chaque borne de commande des transistors (M0, M1) est destinée à recevoir un signal binaire de données respectif (bit0, bit1) dans le dispositif de transmission de signaux UWB pour que le circuit fournisse le premier signal de sortie à impulsions (out0) et le second signal de sortie à impulsions (out1) complémentaire au premier signal de sortie, la forme de chaque impulsion dépendant de la charge et de la décharge de chaque condensateur.

2. Circuit générateur d'impulsions (10) selon la revendication 1, **caractérisé en ce que** les transistors de la paire différentielle sont des transistors MOS (M0, M1).

**3.** Circuit générateur d'impulsions (10) selon la revendication 2, **caractérisé en ce que** les transistors MOS sont du type NMOS, **en ce que** la source de courant (Is) est reliée entre la première borne de source de chaque transistor NMOS et une borne de potentiel bas de la source d'alimentation, et **en ce que** chaque résistance (R0, R1) et chaque condensateur (C0, C1) sont reliés à la seconde borne de drain de chaque transistor correspondant.

**4.** Circuit générateur d'impulsions (10) selon la revendication 3, **caractérisé en ce qu'**une troisième résistance ajustable (Rcm) est reliée entre une borne de potentiel haut (VDD) de la source de tension d'alimentation et un côté de chaque résistance (R0, R1) opposé au noeud de connexion avec le condensateur (C0, C1) correspondant et le transistor (M0, M1) correspondant.

**5.** Circuit générateur d'impulsions (10) selon l'une des revendications précédentes, **caractérisé en ce que** la valeur des résistances (R0, R1, Rcm) est adaptée en fonction de la valeur de courant de la source de courant (Is) pour que les signaux de sortie à impulsions (out0, out1) définissent un code ternaire des données à transmettre.

**6.** Circuit générateur d'impulsions (10) selon la revendication 5, **caractérisé en ce qu'**un état "0" du code ternaire dans le premier signal de sortie (out0) ou le second signal de sortie (out1) est obtenu quand les deux transistors (M0, M1) sont rendus conducteurs, **en ce qu'**un état "1" dans le premier signal de sortie et inversement un état "-1" dans le second signal de sortie est obtenu quand le premier transistor (M0) est non conducteur ou moins conducteur que le second transistor (M1) en conduction, et **en ce qu'**un état "-1" dans le premier signal de sortie et inversement un état "1" dans le second signal de sortie est obtenu quand le second transistor (M1) est non conducteur ou moins conducteur que le premier transistor (M0) en conduction.

**7.** Circuit générateur d'impulsions (10) selon l'une des revendications précédentes, **caractérisé en ce que** la troisième résistance (Rcm) peut être ajustée de manière à produire des impulsions de forme triangulaire ou des impulsions de forme rectangulaire dans le temps.

**8.** Circuit générateur d'impulsions (10) selon l'une des revendications précédentes, **caractérisé en ce que** les impulsions de chaque signal de sortie de durée inférieure ou égale à 2 ns sont de forme déterminée et agencées dans le temps de telle manière à se trouver dans un masque spectral déterminé, tel qu'un masque spectral défini selon un standard IEEE 802.15.4a.

**9.** Circuit générateur d'impulsions (10) selon l'une des revendications précédentes, **caractérisé en ce qu'**il génère des signaux de sortie (out0, out1), qui comprennent pour chaque symbole de données à transmettre, une rafale de plusieurs impulsions de polarité déterminée et agencée dans le temps pour définir une modulation de position de chaque rafale d'impulsions et une modulation de phase à deux états.

**10.** Dispositif de transmission de signaux UWB (1) comprenant un circuit générateur d'impulsions (10) selon l'une des revendications précédentes, qui est combiné à une unité (6) de modulation de position et de phase des impulsions ou rafales d'impulsions, et un générateur de données (2) pour fournir des signaux numériques de commande (s, g0, g1, h) au circuit générateur d'impulsions et à l'unité de modulation de position et de phase des impulsions ou rafales d'impulsions pour permettre au circuit générateur d'impulsions de fournir un premier signal de sortie (out0) et un second signal de sortie (out1) avec des impulsions ou rafales d'impulsions modulées en position et en phase.

**11.** Dispositif de transmission de signaux UWB (1) selon la revendication 10, **caractérisé en ce qu'**il comprend un oscillateur (4) pour fournir au moins un signal à fréquence porteuse, un mélangeur (3) pour mélanger au moins un signal de sortie à impulsions (out0, out1) du circuit générateur d'impulsions (10) et le signal à fréquence porteuse afin de fournir des signaux UWB à fréquence porteuse à une antenne de transmission (5).

**12.** Dispositif de transmission de signaux UWB (1) selon la revendication 11, **caractérisé en ce que** la fréquence porteuse du signal de l'oscillateur est déterminée dans une gamme de fréquence entre 3.1 et 10.6 GHz, et **en ce que** le masque spectral d'un des signaux de sortie du circuit générateur d'impulsions, se situe en dessous de 500 MHz centré sur la fréquence porteuse tenant compte du standard IEEE 802.15.4a.

**13.** Dispositif de transmission de signaux UWB (1) selon l'une des revendications 11 et 12, **caractérisé en ce que** l'oscillateur (4) fournit deux signaux à fréquence porteuse déphasés de 180° l'un de l'autre afin de les mélanger dans le mélangeur (3) chacun respectivement au premier signal de sortie et au second signal de sortie du circuit générateur d'impulsions (10).

# Fig. 1

| Préambule | | |
|---|---|---|

| Synchronisation | Entête | Données / Symboles |
|---|---|---|

# Fig. 4

Symbole (Ts)

Première partie | Seconde partie

rafale

Intervalle rafale | Intervalle de garde | Intervalle rafale | Intervalle de garde

# Fig. 5

Fig. 2

Préambule | Données

Rafale

Amplitude

Temps [μs]

Fig. 3

impulsion    porteuse

Amplitude

Temps [ns]

# Fig. 6

# Fig. 7

## Fig. 8a

Impulsion transmise

## Fig. 8b

Europäisches
Patentamt

European
Patent Office

Office européen
des brevets

# RAPPORT DE RECHERCHE EUROPEENNE

Numéro de la demande

EP 09 17 9459

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2008/111639 A1 (RYCKAERT JULIEN [BE] ET AL) 15 mai 2008 (2008-05-15) <br> * abrégé * <br> * alinéas [0051] - [0053] * <br> * alinéa [0056] * <br> * alinéas [0089] - [0091] * <br> * alinéas [0092] - [0093]; figure 14 * <br> * alinéas [0094], [0098], [0100], [0101], [0102]; figure 15 * <br> * alinéas [0103], [0104]; figure 18 * <br> ----- | 1-13 | INV. <br> H04B1/69 <br> H03K5/08 <br><br> ADD. <br> H03K19/094 |
| A | MARCHALAND D ET AL: "65nm CMOS Burst Generator for Ultra-Wideband Low Data Rate Systems" <br> RADIO FREQUENCY INTEGRATED CIRCUITS (RFIC) SYMPOSIUM, 2007 IEEE, IEEE, PISCATAWAY, NJ, USA, 1 juin 2007 (2007-06-01), pages 43-46, XP031112976 <br> ISBN: 978-1-4244-0530-5 <br> * le document en entier * <br> ----- | 1-13 | |
| A | FR 2 912 014 A1 (ST MICROELECTRONICS SA [FR]) 1 août 2008 (2008-08-01) <br> * page 1, ligne 20-28 * <br> * page 7, ligne 17-31 * <br> * page 8, ligne 12-15; figure 1 * <br> * page 9, ligne 3-13 * <br> * page 16, ligne 14-20; figure 2 * <br> ----- | 1,6,8-13 | DOMAINES TECHNIQUES RECHERCHES (IPC) <br> H04B <br> H03K |

Le présent rapport a été établi pour toutes les revendications

| Lieu de la recherche | Date d'achèvement de la recherche | Examinateur |
|---|---|---|
| Munich | 11 juin 2010 | Martínez Martínez, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 17 9459

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-06-2010

| Document brevet cité au rapport de recherche | Date de publication | Membre(s) de la famille de brevet(s) | Date de publication |
|---|---|---|---|
| US 2008111639 A1 | 15-05-2008 | AUCUN | |
| FR 2912014 A1 | 01-08-2008 | US 2008205486 A1 | 28-08-2008 |

Pour tout renseignement concernant cette annexe : voir Journal Officiel de l'Office européen des brevets, No.12/82

EPO FORM P0460

**RÉFÉRENCES CITÉES DANS LA DESCRIPTION**

**Documents brevets cités dans la description**

- WO 2005067160 A